# EUROPÄISCHE PATENTSCHRIFT

(11) **EP 1 402 615 B1**
(45) Veröffentlichungstag und Bekanntmachung des Hinweises auf die Patenterteilung: **01.10.2014**
(21) Anmeldenummer: 02701232.7
(22) Anmeldetag: 25.01.2002
(51) Int. Cl.: H02K 5/14, H02K 11/02

(54) **GEHÄUSETEIL FÜR EINEN ELEKTRISCHEN VERSTELLANTRIEB**
HOUSING PART FOR AN ELECTRIC ADJUSTING DRIVE
PARTIE DE BOITIER POUR ENTRAINEMENT D'AJUSTAGE ELECTRIQUE

(30) Priorität: 16.06.2001 DE 10129118
(43) Veröffentlichungstag der Anmeldung: 31.03.2004
(73) Patentinhaber: ROBERT BOSCH GMBH, 70442 Stuttgart (DE)
(72) Erfinder: FELGUEROSO, Inigo, 77815 Buehl (DE); MERKEL, Wilfried, 77876 Kappelrodeck (DE); ALBRECHT, Gerard, F-67690 Hatten (FR); BOHN, Roland, 77815 Buehl (DE); GMUEND, Rudolf, 76437 Rastatt (DE)
(86) Internationale Anmeldenummer: PCT/DE2002/000248
(87) Internationale Veröffentlichungsnummer: WO 2002/103884

(56) Entgegenhaltungen:
- EP-A- 1 075 076
- FR-A- 2 797 110
- US-A- 4 593 220
- PATENT ABSTRACTS OF JAPAN vol. 1997, no. 08, 29. August 1997 (1997-08-29) -& JP 09 106870 A (MITSUBISHI ELECTRIC CORP), 22. April 1997 (1997-04-22)

## Beschreibung

### Stand der Technik

Die Erfindung geht aus einem Gehäuseteil für einen elektrischen Verstellantrieb nach der Gattung des Anspruchs 1.

Aus der EP 0 639 884 B1 bzw. US-PS 5,521,785 ist es bekannt, ein Stanzgitter mit Kunststoff zu umspritzen, wobei an die Kunststoffumspritzung Gehäuseteile für einen Elektromotor montiert werden.

Die DE 197 02 833 A1 bzw. US-PS 5,762,579 zeigt ein Getriebegehäusedeckel, an dem ein Stanzgitter mit Schleifkontakten angeordnet ist.

Mit der JP-A-09106870 ist ein Bürstenhalterbauteil bekannt geworden, bei dem Kohlebürsten für einen Schleifkontakt mit entsprechenden Schleifringen gehalten werden. Dabei wird die elektrische Kontaktierung der Kohlebürsten innerhalb der Wand des Bürstenhalterbauteils zu einem äußeren Steckeranschluß geführt.

### Vorteile der Erfindung

Das erfindungsgemässe Gehäuseteil mit den kennzeichnenden Merkmalen des Anspruchs 1 hat demgegenüber den Vorteil, dass auf einfache Art und Weise viele Bauteile eines elektrischen Verstellantriebs in bzw. an dem Gehäuseteil integriert sind und so die Montagezeiten und die Anzahl der zu montierenden Teile reduziert sind.

Durch die in den abhängigen Ansprüchen aufgeführten Massnahmen sind vorteilhafte Weiterbildungen und Verbesserungen des in Anspruch 1 genannten Gehäuseteils möglich.

Vorteilhafterweise verwendet man für die inneren Leiterbahnen oder die äusseren Leiterbahnen ein Stanzgitter, weil diese einfach aus einem Blech herzustellen und zu verbiegen sind.

Die äusseren Leiterbahnen können auf vorteilhafte Weise Schleifkontakte aufweisen, die mit Schleifbahnen des elektrischen Verstellantriebs eine Steuerung des elektrischen Verstellantriebs ermöglichen.

Das Gehäuseteil kann auf vorteilhafte Weise Mulden aufweisen, in denen elektrische Elemente wie Thermoschutzschalter, Entstördrossel, Kondensator, usw. angeordnet sind, wodurch eine Halterung der elektrischen Elemente am Gehäuseteil erleichtert ist.

Die inneren Leiterbahnen bilden auf vorteilhafte Weise Steckkontakte für einen Stecker, wobei das Steckergehäuse vorteilhafterweise einteilig mit dem Gehäuseteil ausgebildet ist. Dies reduziert die zu montierenden Teile.

Das Gehäuseteil weist mindestens einen Befestigungsfuss auf, mit dem der elektrische Verstellantrieb bspw. an eine Halterung befestigt werden kann, wenn das Gehäuseteil mit dem elektrischen Verstellantrieb verbunden ist.

Es ist vorteilhaft, wenn das Gehäuseteil einen einteilig mit diesem ausgebildeten Bürstenhalter aufweist, weil so die Montage eines zusätzlichen Bürstenhalters am Gehäuseteil oder am Motorgehäuse des elektrischen Verstellantriebs entfällt.

### Zeichnung

Ausführungsbeispiele der Erfindung sind in der Zeichnung vereinfacht dargestellt und in der nachfolgenden Beschreibung näher erläutert.

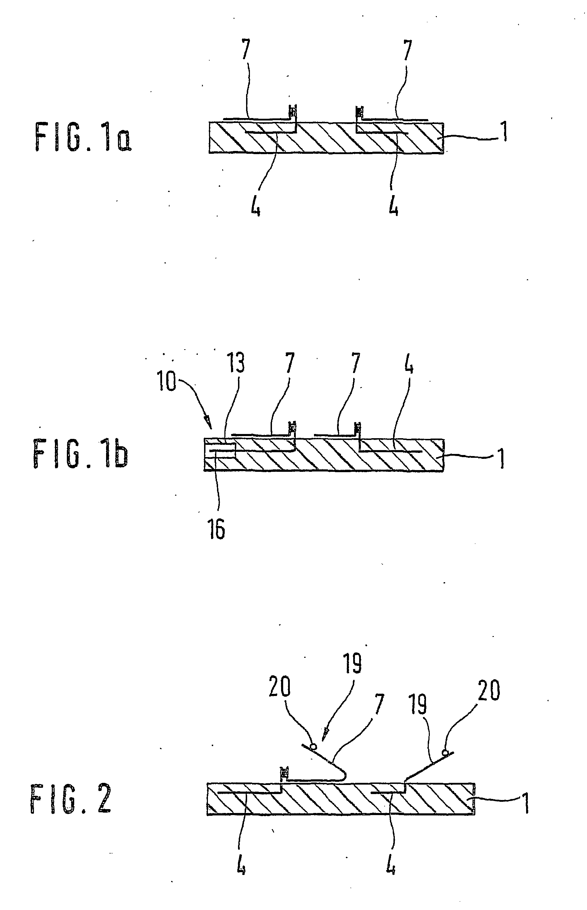

Es zeigen
Figur la ein erfindungsgemäss ausgebildetes Gehäuseteil mit inneren und äusseren Leiterbahnen, Figur 1b ein erfindungsgemäss ausgebildetes Gehäuseteil, gemäß Figur 1a mit einem Steckergehäuse,
Figur 2 ein erfindungsgemäss ausgebildetes Gehäuseteil, gemäß Figur 1a mit Schleifkontakten,
Figur 3 die Anordnung von elektrischen Elementen in Mulden eines erfindungsgemäss ausgebildeten Gehäuseteils und die elektrische Kontaktierung derer mittels Schneidklemmkontakten,
Figur 4 ein erfindungsgemäss ausgebildetes Gehäuseteil mit Befestigungsfüssen,
Figur 5 einen Bürstenhalter, der einteilig mit dem erfindungsgemäss ausgebildeten Gehäuseteil ausgebildet ist, und
Figur 6 ein Ausführungsbeispiel eines erfindungsgemäss ausgebildeten Gehäuseteils.

### Beschreibung der Ausführungsbeispiele

Figur 1a zeigt in Teilansicht im Schnitt ein erfindungsgemässes Gehäuseteil 1 bspw. aus Kunststoff, in dem bspw. durch Kunststoffumspritzung oder durch Umgiessen zumindest teilweise zumindest eine innere elektrische Leiterbahn 4 angeordnet ist.

Das Gehäuseteil 1 kann ein Deckel oder ein Boden bzw. Oberteil oder Unterteil eines Getriebegehäuses und/oder eines Motorgehäuses eines elektrischen Verstellantriebs sein, wie z.B. eines Scheibenwischerantriebs oder eines Fensterheberantriebs für Kraftfahrzeuge.

Die inneren Leiterbahnen 4 können elektrische Kabel sein. Vorzugsweise sind sie Leiterbahnen 4 beispielsweise durch ein Stanzgitter gebildet.

Die inneren Leiterbahnen 4 ragen zumindest zum Teil aus dem Gehäuseteil 1 heraus und sind bspw. ausserhalb des Gehäuseteils 1 elektrisch leitend mit zumindest einer äusseren Leiterbahn 7 verbunden, wobei keine Anschlussfahnen elektrischer Bauteile gemeint sind.

Die äusseren Leiterbahnen 7 sind bspw. ebenfalls durch ein Stanzgitter gebildet und werden bspw. durch die elektrische und damit auch mechanische Kontaktierung an den fest im Gehäuseteil 1 umschlossenen inneren Leiterbahnen 4 am Gehäuseteil 1 gehalten. Zusätzlich kann das Gehäuseteil 1 mit den äusseren Leiterbahnen 7 durch weitere Befestigungselemente wie Rast- und Klemmverbindungen verbunden sein.

Ein Stecker 10 wird durch ein Teil der inneren Leiterbahn 4, die aus dem Gehäuseteil 1 herausragt, nämlich die Steckkontakte 16, und ein Steckergehäuse 13, als ein Teil des Gehäuseteils 1 gebildet (Fig. 1b). Das Steckergehäuse 13 kann auch separat vom Gehäuseteil 1 ausgebildet sein, damit es kundenspezifischen Wünschen angepasst werden kann.

Der Stecker 10 dient zum Anschluss an eine äussere elektrische Energiequelle, die elektrische Elemente, die am Gehäuseteil 1 angeordnet sind, mit elektrischem Strom oder Spannung versorgt.

Figur 2 zeigt einen Teil eines erfindungsgemäss ausgebildeten Gehäuseteiles 1, bei dem ein Ende der äusseren elektrischen Leiterbahn 7 bspw. um mehr als 90° aus ihrer Befestigungsebene umgebogen ist, so dass es Schleifkontakte 19 bildet.

Die Schleifkontakte 19 können auch von inneren Leiterbahnen 4 gebildet sein.

Die Schleifkontakte 19 sind federnd ausgebildet, d.h. man muss eine Kraft aufwenden, um sie zum Gehäuseteil 1 hinzudrücken, wobei sie nach Rücknahme der Kraft wieder zurückfedern.

Ein elektrischer Kontaktpunkt 20 am Ende des Schleifkontakts 19 bildet den elektrischen Kontakt mit einer nicht dargestellten Schleifbahn an einen anderen Gehäuseteil.

Mit elektrischen Schleifbahnen, die im elektrischen Verstellantrieb, bspw. im Getriebegehäuse angeordnet sind, kann der elektrische Verstellantrieb bspw. ein- und ausgeschaltet werden.

Als Material für den Kontaktpunkt 20 wird bspw. Kupfer verwendet, und er ist bspw. zumindest teilweise kugelförmig ausgebildet.

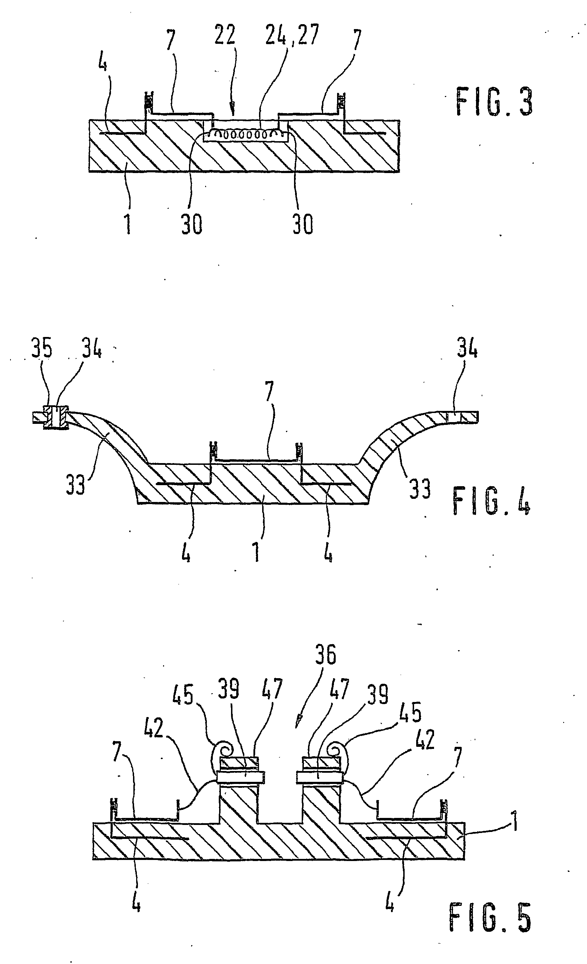

Figur 3 zeigt die Anordnung von zumindest einem elektrischen Element 24 in zumindest einer Mulde 22 eines erfindungsgemäss ausgebildeten Gehäuseteils 1.

In einer Mulde 22 des Gehäuseteils 1 ist als ein elektrisches Element 24 beispielsweise eine elektrische Entstördrossel 27 angeordnet. Die Mulde 22 ist bspw. so ausgebildet, dass die Entstördrossel 27 in ihr eingeklemmt und so gehalten ist. Die Enstördrossel 27 kann auch lose in der Mulde 22 angeordnet sein, wobei eine sichere Befestigung am Gehäuseteil 1 durch den elektrischen und damit mechanischen Kontakt mit den mechanisch steifen äusseren Leiterbahnen 7 erfolgt.

Die Entstördrossel 27 ist an ihren beiden Enden mittels sogenannten Schneidklemmverbindungen 30 oder durch Lötung bzw. Schweissung mit Enden der äusseren elektrischen Leiterbahn 7 verbunden. Kondensatoren zur Dämpfung im elektrischen Stromkreis und/oder Thermoschutzelemente gegen ein Überhitzen der elektrischen Elemente 24 und Drehratensensoren stellen weitere elektrische Elemente 24 dar, die am Gehäuseteil 1 vorzugsweise in der Mulde 22 angeordnet sind.

Zur Montage des Verstellantriebs (nicht gezeigt) sind bspw. Befestigungsfüsse 33 notwendig (Fig. 4), um so den Verstellantrieb bspw. an einer Wand, bspw. einer Innenwand eines KFZ's zu befestigen. Die Befestigungsfüsse 33 sind beispielsweise einteilig am erfindungsgemäss ausgebildeten Gehäuseteil 1 ausgebildet. In diesem Beispiel werden zwei Befestigungsfüsse 33 verwendet. Die Befestigungsfüsse 33 können spezifisch Kundenanforderungen angepasst werden.

An ihren Enden sind bspw. Befestigungslöcher 34 vorgesehen, durch die bspw. Schrauben hindurchgeführt werden. Am Befestigungsloch 34 kann ausserdem ein Gummiring 35 zur Dämpfung des Verstellantriebs gegenüber der Befestigungswand vorgesehen sein.

Figur 5 zeigt einen Bürstenhalter 36, der mit dem erfindungsgemäss ausgebildeten Gehäuseteil 1 gemäß den Figuren 1a, 1b, 2, 3, 4 bspw. einteilig ausgeführt ist.

Der Bürstenhalter 36 besteht aus zumindest einer Bürste 39, die an einem Kommutator (nicht gezeigt) eines elektrischen Motors der elektrischen Antriebseinheit zum Anliegen kommt. Die Bürste 39 wird mittels einer Feder 45 an den Kommutator angedrückt. Die elektrische Stromversorgung erfolgt über den äusseren Stecker 10, Steckkontakte 16, innere Leiterbahnen 4, äussere Leiterbahnen 7, die dann wiederum mittels Bürstenlitzen 42 mit der Bürste 39 elektrisch verbunden sind.

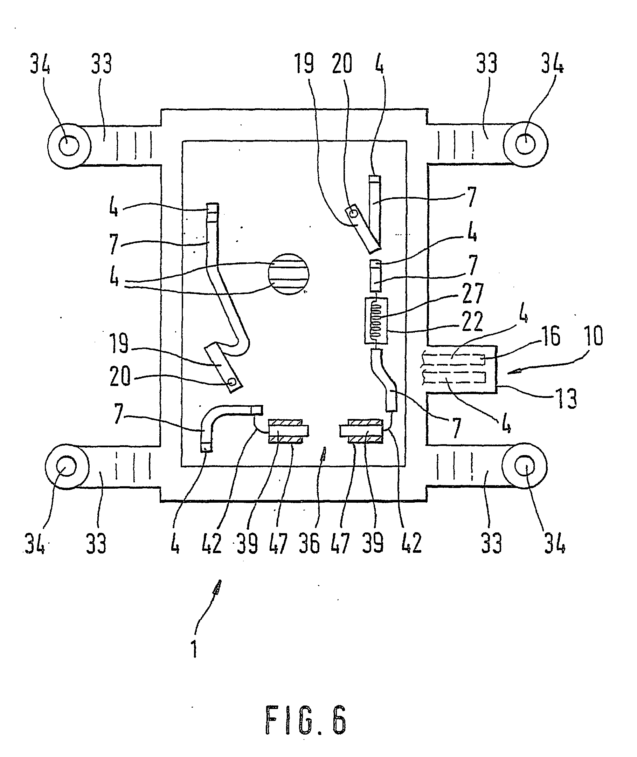

Figur 6 zeigt eine Aufsicht auf ein erfindungsgemäss ausgebildetes Gehäuseteil 1 mit den Teilen der Figuren 1a,1b und 2 bis 5.

Die Schleifkontakte 19 sind elektrisch leitend mit den inneren Leiterbahnen 4 verbunden, die innerhalb des Gehäuseteils 1 bis zum Steckergehäuse 13 verlaufen (im Steckergehäuse 13 gestrichelt angedeutet). Dort sind sie über einen äusseren Stecker (nicht gezeigt) mit einer Steuerungselektronik verbunden. Die Steuerungselektronik kann auch am Getriebgehäuseteil 1 angeordnet sein.

Der Bürstenhalter 36 wird durch bspw. zwei Erhebungen 47 gebildet, in denen die Bürsten 39 geführt werden.

## Patentansprüche

1. Gehäuseteil **eines** elektrischen Verstellantriebs,
das zumindest eine elektrische innere Leiterbahn zumindest teilweise umschliesst, **wobei** zumindest eine elektrische äussere Leiterbahn (7) an dem Gehäuseteil (1) angeordnet ist, und zumindest eine elektrische äussere Leiterbahn (7) mit der zumindest einen inneren Leiterbahn (4) elektrisch kontaktiert ist, **dadurch gekennzeichnet, dass**
**das Gehäuseteil (1) ein Gehäuseteil eines Getriebegehäuses des elektrischen Verstellantriebs ist.**

2. Gehäuseteil nach Anspruch 1,
**dadurch gekennzeichnet, dass**
die zumindest eine innere Leiterbahn (4) als ein Stanzgitter ausgebildet ist.

3. Gehäuseteil nach Anspruch 1,
**dadurch gekennzeichnet, dass**
die zumindest eine äussere Leiterbahn (7) als ein Stanzgitter ausgebildet ist.

4. Gehäuseteil nach Anspruch 1 oder 3,
**dadurch gekennzeichnet, dass**
die zumindest eine äussere Leiterbahn (7) zumindest einen Schleifkontakt (19) aufweist.

5. Gehäuseteil nach Anspruch 1,
**dadurch gekennzeichnet, dass**
das Gehäuseteil (1) zumindest eine Mulde (22) aufweist, in der zumindest ein elektrisches Element (24) angeordnet ist.

6. Gehäuseteil nach Anspruch 5,
**dadurch gekennzeichnet, dass**
das elektrisches Element (24) eine Entstördrossel (27) ist.

7. Gehäuseteil nach Anspruch 5,
**dadurch gekennzeichnet, dass**
das elektrisches Element (24) ein Thermoschutzschalter ist.

8. Gehäuseteil nach Anspruch 1,
**dadurch gekennzeichnet, dass**
an dem Gehäuseteil (1) ein Steckergehäuse (13) angeordnet ist.

9. Gehäuseteil nach Anspruch 8,
**dadurch gekennzeichnet, dass**
das Steckergehäuse (13) mit dem Gehäuseteil (1) einteilig ausgebildet ist.

10. Gehäuseteil nach Anspruch 8 oder 9,
**dadurch gekennzeichnet, dass**
die inneren Leiterbahnen (4) mit dem Steckergehäuse (13) einen Stecker (10) bilden.

11. Gehäuseteil nach Anspruch 1,
**dadurch gekennzeichnet, dass**
das Gehäuseteil (1) mindestens einen Befestigungsfuss (33) aufweist.

12. Gehäuseteil nach Anspruch 1,
**dadurch gekennzeichnet, dass**
mit dem Gehäuseteil (1) ein Bürstenhalter (36) einteilig ausgebildet ist.

13. Gehäuseteil nach Anspruch 1 oder 3,
**dadurch gekennzeichnet, dass**
die äusseren Leiterbahnen (7) Schneidklemmverbindungen zur elektrischen Kontaktierung aufweisen.

14. Gehäuseteil nach Anspruch 1,
**dadurch gekennzeichnet, dass**
das Gehäuseteil (1) ein Getriebegehäusedeckel ist.

15. Gehäuseteil nach Anspruch 1,
**dadurch gekennzeichnet, dass**
das Gehäuseteil (1) ein Getriebegehäuseboden ist.

16. **Gehäuseteil nach Anspruch 1,**
**dadurch gekennzeichnet, dass**
**die zumindest eine innere Leiterbahn (4) mit Kunststoff umspritzt ist.**

## Claims

1. Housing part of an electric adjusting drive, which housing part at least partially surrounds at least one electrical inner conductor track, wherein at least one electrical outer conductor track (7) is arranged on the housing part (1), and the at least one inner conductor track (4) makes electrical contact with at least one electrical outer conductor track (7), **characterized in that** the housing part (1) is a housing part of a gear mechanism housing of the electric adjusting drive.

2. Housing part according to Claim 1, **characterized in that** the at least one inner conductor track (4) is in the form of a stamped grid.

3. Housing part according to Claim 1, **characterized in that** the at least one outer conductor track (7) is in the form of a stamped grid.

4. Housing part according to Claim 1 or 3, **characterized in that** the at least one outer conductor track (7) has at least one sliding contact (19).

5. Housing part according to Claim 1, **characterized in that** the housing part (1) has at least one recess (22) in which at least one electrical element (24) is arranged.

6. Housing part according to Claim 5, **characterized in that** the electrical element (24) is an interference-suppression choke (27).

7. Housing part according to Claim 5, **characterized in that** the electrical element (24) is a thermal circuit breaker.

8. Housing part according to Claim 1, **characterized in that** a plug housing (13) is arranged on the housing part (1).

9. Housing part according to Claim 8, **characterized in that** the plug housing (13) is integrally formed with the housing part (1).

10. Housing part according to Claim 8 or 9, **characterized in that** the inner conductor tracks (4) form a plug (10) with the plug housing (13).

11. Housing part according to Claim 1, **characterized in that** the housing part (1) has at least one mounting foot (33).

12. Housing part according to Claim 1, **characterized in that** a brush holder (36) is integrally formed with the housing part (1).

13. Housing part according to Claim 1 or 3, **characterized in that** the outer conductor tracks (7) have insulation-displacement terminal connections for the purpose of making electrical contact.

14. Housing part according to Claim 1, **characterized in that** the housing part (1) is a gear mechanism housing cover.

15. Housing part according to Claim 1, **characterized in that** the housing part (1) is a gear mechanism housing base.

16. Housing part according to Claim 1, **characterized in that** the at least one inner conductor track (4) is encapsulated in plastic by injection-moulding.

## Revendications

1. Partie de boîtier d'un mécanisme de positionnement électrique, lequel entoure au moins partiellement au moins une piste conductrice électrique interne, au moins une piste conductrice électrique externe (7) étant disposée sur la partie de boîtier (1) et au moins une piste conductrice électrique externe (7) étant mise en contact électrique avec l'au moins une piste conductrice interne (4), **caractérisée en ce que** la partie de boîtier (1) est une partie de boîtier d'un carter d'engrenage du mécanisme de positionnement électrique.

2. Partie de boîtier selon la revendication 1, **caractérisée en ce que** l'au moins une piste conductrice interne (4) est réalisée sous la forme d'une grille estampée.

3. Partie de boîtier selon la revendication 1, **caractérisée en ce que** l'au moins une piste conductrice externe (7) est réalisée sous la forme d'une grille estampée.

4. Partie de boîtier selon la revendication 1 ou 3, **caractérisée en ce que** l'au moins une piste conductrice externe (7) présente au moins un contact à frottement (19).

5. Partie de boîtier selon la revendication 1, **caractérisée en ce que** la partie de boîtier (1) présente au moins une cavité (22) dans laquelle est disposé au moins un élément électrique (24).

6. Partie de boîtier selon la revendication 5, **caractérisée en ce que** l'élément électrique (24) est une bobine d'antiparasitage (27).

7. Partie de boîtier selon la revendication 5, **caractérisée en ce que** l'élément électrique (24) est un thermostat de protection.

8. Partie de boîtier selon la revendication 1, **caractérisée en ce que** sur la partie de boîtier (1) est disposé un boîtier de fiche (13).

9. Partie de boîtier selon la revendication 8, **caractérisée en ce que** le boîtier de fiche (13) est réalisé d'une seule pièce avec la partie de boîtier (1).

10. Partie de boîtier selon la revendication 8 ou 9, **caractérisée en ce que** les pistes conductrices internes (4) forment une fiche (10) avec le boîtier de fiche (13).

11. Partie de boîtier selon la revendication 1, **caractérisée en ce que** la partie de boîtier (1) présente au moins un pied de fixation (33).

12. Partie de boîtier selon la revendication 1, **caractérisée en ce qu'**un porte-balai (36) est réalisé d'une seule pièce avec la partie de boîtier (1).

13. Partie de boîtier selon la revendication 1 ou 3, **caractérisée en ce que** les pistes conductrices externes (7) présentent des raccords à borne guillotine pour l'établissement du contact électrique.

14. Partie de boîtier selon la revendication 1, **caractérisée en ce que** la partie de boîtier (1) est un couvercle de carter d'engrenage.

15. Partie de boîtier selon la revendication 1, **caractérisée en ce que** la partie de boîtier (1) est un fond de carter d'engrenage.

16. Partie de boîtier selon la revendication 1, **caractérisée en ce que** l'au moins une piste conductrice interne (4) est enrobée de matière plastique.
